# EUROPEAN PATENT APPLICATION

(11) **EP 3 761 764 A1**
(43) Date of publication of application: **06.01.2021**
(21) Application number: 19761715.2
(22) Date of filing: 26.02.2019
(51) Int. Cl.: H05K 1/02, H01L 23/12, H01L 23/13, H01L 23/36, H05K 3/20

(54) **INSULATING CIRCUIT BOARD**

(30) Priority: 27.02.2018 JP 2018032799
(71) Applicant: Mitsubishi Materials Corporation, Tokyo 100-8117 (JP)
(72) Inventor: KITAHARA, Takeshi, Saitama-shi, Saitama 330-8508 (JP); OOHIRAKI, Tomoya, Saitama-shi, Saitama 330-8508 (JP); NAGATOMO, Yoshiyuki, Saitama-shi, Saitama 330-8508 (JP)
(74) Representative: Hoffmann Eitle
(86) International application number: PCT/JP2019/007316
(87) International publication number: WO 2019/167942

(57) **Abstract**

Provided is an insulated circuit board including a ceramic substrate, a circuit layer that has a circuit pattern formed thereon and is bonded to one surface of the ceramic substrate, and a metal layer that is bonded to the other surface of the ceramic substrate, the ceramic substrate has a three-point bending strength, which is based on JIS 1601 2008, of 600 MPa or more, the circuit layer and the metal layer are made of copper or a copper alloy, the circuit layer is formed of a plurality of punched sheets bonded to the ceramic substrate at an interval, the thickness of the circuit layer is 0.4 mm or more and 2.0 mm or less, when the bonding area of the circuit layer is represented by S1, and the bonding area of the metal layer is represented by S2, the area ratio S1/S2 is 0.5 or more and 0.8 or less, and, when the thickness of the circuit layer is represented by T1, and the thickness of the metal layer is represented by T2, the thickness ratio T1/T2 is 1.2 or more and 1.7 or less.

## Description

### BACKGROUND OF THE INVENTION

### Technical Field

The present invention relates to an insulated circuit board such as a power module board that is used in a semiconductor device configured to control a large current and a high voltage.

The present application claims priority based on Japanese Patent Application No. 2018-032799, filed on February 27, 2018, and the content thereof is incorporated herein by reference.

### Background Art

As a power module board, known is a power module board in which a circuit layer is bonded to one surface of an insulated substrate made of ceramic such as aluminum nitride and a metal layer is bonded to the other surface.

For example, in a power module board disclosed in Patent Document 1, each of a circuit layer and a metal layer bonded to an insulated substrate is made of pure copper having a purity of 99.999% or more. Therefore, the repeated exertion of a temperature cycle causes recrystallization in the circuit layer and the metal layer, which is capable of preventing cracks by reducing internal stress generated in the circuit layer and the metal layer.

In recent years, high-strength silicon nitride ceramic (Si₃N₄) substrates have been often used as insulated substrates. Silicon nitride ceramic substrates have a higher strength and a higher thermal conductivity than ceramic substrates made of aluminum nitride. Therefore, it is possible to decrease the thickness of the insulated substrate compared with insulated substrates made of aluminum nitride, and accordingly, it is possible to increase the thicknesses of the circuit layer and the metal layer compared with those in the related art (for example, 0.4 mm or more).

### Citation List

### Patent Literature

Patent Document 1: JP-A-2004-221547

### SUMMARY OF INVENTION

### Technical Problem

However, when an insulated substrate (ceramic substrate) is made of silicon nitride ceramic, and a circuit layer and a metal layer are made of copper or a copper alloy, since the difference in the linear expansion coefficient (thermal expansion rate) is large between the ceramic substrate and the circuit layer and between the ceramic substrate and the metal layer, after the circuit layer and the metal layer are bonded to the ceramic substrate, residual stresses in the ceramics substrate are large, and warpage is caused. In addition, due to the decrease in the thickness of the ceramic substrate and the increase in the thickness of the copper circuit layer, a warpage change during the soldering of the insulated circuit board becomes large, which hinders soldering. As a result, there is a desire for an insulated circuit board that changes only to a small extent due to warpage at a high temperature.

In the related art, a pattern is formed on the circuit layer in the insulated circuit board using an etching method. However, the etching method creates a constraint on the structural design such as a need for integrating a lead frame and the circuit layer or a need for the size of the metal layer to be larger than the size of the ceramic substrate in order to secure the soldering reliability between the ceramic substrate and the circuit layer and between the ceramic substrate and the metal layer.

Therefore, it is conceivable to form a metal sheet having a pattern by a pressing method without using the etching method and bond the metal sheet to the ceramic substrate, but a change caused by warpage at a high temperature during soldering becomes more significant.

The present invention has been made in consideration of such circumstances, and an object of the present invention is to provide an insulated circuit board capable of suppressing a warpage change at a high temperature during soldering while allowing the use of a metal sheet punched by pressing.

### Solution to Problem

Regarding residual stresses that are generated on the surfaces of the ceramic substrate, on the bonding surface with the circuit layer or the metal layer, a compressive stress is generated. However, since patterns are formed on the circuit layer side, in the portion between the patterns, a tensile stress is generated on the side of the circuit layer, and a compressive stress is generated on the other side. Therefore, the ceramic substrate is likely to warp such that the circuit layer side becomes convex. In this case, as the circuit layer and the metal layer become thicker, the ceramic substrate more significantly warps.

As a result of intensive research, the present inventors found that it is possible to suppress warpage by appropriately controlling the thicknesses of the circuit layer and the metal layer.

An insulated circuit board of the present invention includes a ceramic substrate having a three-point bending strength, which is based on JIS 1601 2008, of 600 MPa or more; a circuit layer that is made of copper or a copper alloy, includes a plurality of small circuit layers that is bonded to one surface of the ceramic substrate at an interval so as to form a predetermined shape, and has a thickness T1 of 0.4 mm or more and 2.0 mm or less; and a metal layer that is made of copper or a copper alloy and is bonded to the other surface of the ceramic substrate, in which, when a bonding area of the circuit layer to the ceramic substrate is represented by S1, and a bonding area of the metal layer to the ceramic substrate is represented by S2, an area ratio S1/S2 is 0.5 or more and 0.8 or less, and, when a thickness of the circuit layer is represented by T1, and a thickness of the metal layer is represented by T2, a thickness ratio T1/T2 is 1.2 or more and 1.7 or less.

In the present invention, even when a residual stress is generated between circuit patterns (between the small circuit layers in the circuit layer) on the ceramic substrate, since the thickness of the metal layer is thinner than the thickness of the circuit layer, it is possible to maintain the balance of stress between the circuit layer-side surface and the metal layer-side surface of the ceramic substrate. Therefore, it is possible to suppress a warpage change caused by a high temperature during soldering.

When the thickness ratio T1/T2 is less than 1.2, it is not possible to eliminate warpage that makes the circuit layer side convex. When the thickness ratio T1/T2 exceeds 1.7, the metal layer becomes too thin, and the warpage change at a high temperature becomes large. In a case where the area ratio S1/S2 is 0.5 or more and 0.8 or less, setting the thickness ratio T1/T2 as described above is effective for suppressing warpage.

The above-described three-point bending strength is a strength based on JIS 1601 2008 standard and refers to the maximum bending stress when a test piece (ceramic substrate) placed on two fulcrums disposed at a certain distance breaks under the application of a load to one point in the middle between the fulcrums.

As a preferred aspect of the insulated circuit board of the present invention, the ceramic substrate is preferably made of silicon nitride.

In the circuit layer of the insulated circuit board of the present invention, the small circuit layer may be made of a punched sheet. According to the present invention, even in a case where a punched sheet is bonded at a high temperature by brazing or the like as the small circuit layer that forms a predetermined shape corresponding to the circuit pattern, it is possible to suppress deformation caused by heating and cooling.

In the circuit layer of the insulated circuit board of the present invention, each of the small circuit layers may be a flat sheet having a polygonal shape such as a rectangular shape. When each of the small circuit layers has a polygonal shape such as a rectangular shape, since the interval between the small circuit layers is linearly formed, there is a concern that the warpage of the ceramic substrate may become significant. However, according to the present invention, it is possible to suppress warpage.

In the circuit layer of the insulated circuit board of the present invention, the interval between the plurality of small circuit layers may be 0.5 mm or more and 2.0 mm or less.

In the circuit layer of the insulated circuit board of the present invention, the plurality of small circuit layers may have the same composition.

In the insulated circuit board of the present invention, the circuit layer and the metal layer may have the same composition.

### Advantageous Effects of Invention

According to the present invention, it is possible to suppress a warpage change at a high temperature during soldering of an insulated circuit board.

### BRIEF DESCRIPTION OF DRAWINGS

FIG. 1 is a cross-sectional view of a power module in which an insulated circuit board according to an embodiment of the present invention is used.
FIG. 2A is a plan view of the insulated circuit board in the embodiment as viewed from a circuit layer side.
FIG. 2B is a plan view of the insulated circuit board in the embodiment as viewed from a metal layer side.
FIG. 3A is a cross-sectional view for describing a method for manufacturing the insulated circuit board shown in FIG. 1.
FIG. 3B is a cross-sectional view for describing the method for manufacturing the insulated circuit board shown in FIG. 1.
FIG. 3C is a cross-sectional view for describing the method for manufacturing the insulated circuit board shown in FIG. 1.

### DESCRIPTION OF EMBODIMENTS

Hereinafter, an embodiment of the present invention will be described with reference to the drawings.

### [Schematic configuration of insulated circuit board]

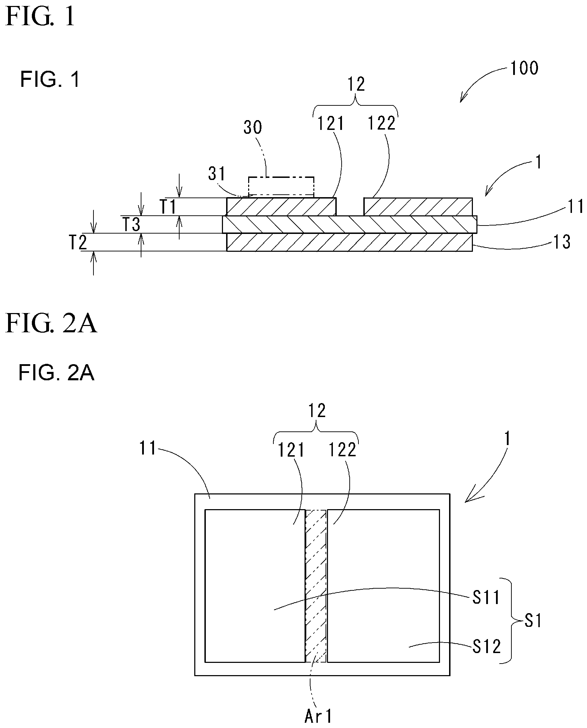

An insulated circuit board 1 that is manufactured by a method for manufacturing an insulated circuit board according to the present invention is a so-called power module board as shown in FIG. 1, and an element 30 is mounted on a surface of the insulated circuit board 1 as shown by a chain double-dashed line in FIG. 1 to configure a power module 100. The element 30 is an electronic component including a semiconductor, and a variety of semiconductor elements such as an insulated gate bipolar transistor (IGBT), a metal oxide semiconductor field effect transistor (MOSFET), and a freewheeling diode (FWD) semiconductor element are selected.

While not shown, the element 30 is provided with an upper electrode portion on the upper portion and a lower electrode portion on the lower portion. The lower electrode portion is bonded to the upper surface of a circuit layer 12 with solder 31 or the like, whereby the element 30 is mounted on the upper surface of the circuit layer 12. The upper electrode portion of the element 30 is connected to a circuit electrode portion or the like of the circuit layer 12 through a lead frame or the like bonded with solder or the like.

### [Configuration of insulated circuit board]

The insulated circuit board 1 includes a ceramic substrate 11, the circuit layer 12 that is bonded to one surface of the ceramic substrate 11 and includes a plurality of small circuit layers 121 and 122, and a metal layer 13 bonded to the other surface of the ceramic substrate 11.

The ceramic substrate 11 is an insulated substrate that prevents electrical connection between the circuit layer 12 and the metal layer 13, the sheet thickness T3 of the ceramic substrate 11 is 0.2 mm to 1.0 mm, and the three-point bending strength is 600 MPa or more. The ceramic substrate 11 is configured using, for example, a silicon nitride ceramic (Si₃N₄) or zirconia-reinforced alumina substrate. In this case, it is possible to increase the strength and the heat transfer coefficient of the ceramic substrate compared with those of a ceramic substrate made of aluminum nitride (AIN).

The ceramic substrate 11 of the present embodiment is made of silicon nitride ceramic and has a sheet thickness T3 set to 0.32 mm and a three-point bending strength set to 600 MPa or more and 1020 MPa or less.

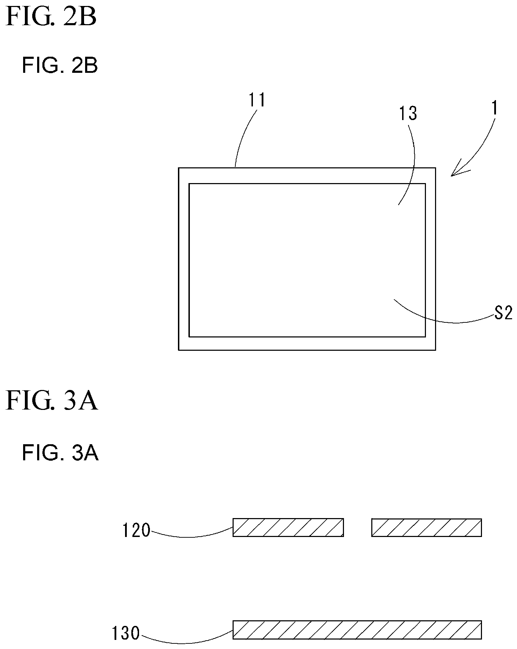

In the example shown in FIG. 1 and FIGS. 2A and 2B, the circuit layer 12 includes two separated small circuit layers 121 and 122. The small circuit layers 121 and 122 each have a polygonal shape (a rectangular shape in the present embodiment) and are separately bonded to one surface of the ceramic substrate 11 at an interval (for example, 0.5 mm to 2.0 mm).

The circuit layer 12 (each of the small circuit layers 121 and 122) is formed of copper such as oxygen-free copper or a copper alloy such as a zirconium-added copper alloy, and the sheet thickness T1 of the circuit layer 12 is set to 0.4 mm or more and 2.0 mm or less. The sheet thickness T1 is larger than the sheet thickness T2 of the metal layer 13, and the thickness ratio T1/T2 is set to 1.2 or more and 1.7 or less. In the circuit layer 12 of the present embodiment, both the small circuit layers 121 and 122 have the same composition.

The circuit layer 12 of the present embodiment is made of oxygen-free copper and has a sheet thickness T1 set to 0.8 mm. The interval between the small circuit layers 121 and 122 is set to 1.0 mm.

The metal layer 13 is made of high-purity copper such as oxygen-free copper or a copper alloy such as a zirconium-added copper alloy, and the sheet thickness T2 of the metal layer 13 is set to 0.3 mm or more and 1.6 mm or less. As described above, the sheet thickness T2 of the metal layer 13 is smaller than the sheet thickness T1 of the circuit layer 12, and the thickness ratio T1/T2 is set to 1.2 or more and 1.7 or less.

The metal layer 13 of the present embodiment is made of oxygen-free copper having the same composition as the oxygen-free copper of the circuit layer 12 and has a sheet thickness set to 0.6 mm.

In the insulated circuit board 1 configured as described above, when the bonding area of the circuit layer 12 is represented by S1 (mm²), and the bonding area of the metal layer 13 is represented by S2 (mm²), the area ratio S1/S2 is adjusted to a relationship in which the area ratio becomes 0.5 or more and 0.8 or less. The bonding areas S1 and S2 are values at 30°C.

In the present embodiment, since the circuit layer 12 includes the small circuit layers 121 and 122, the bonding area S1 of the circuit layer 12 is the sum of the bonding area S11 of the small circuit layer 121 and the bonding area S12 of the small circuit layer 122.

### [Method of manufacturing insulated circuit board]

Next, a method for manufacturing the insulated circuit board 1 of the present embodiment will be described. The method for manufacturing the insulated circuit board 1 includes a metal sheet formation step of pressing sheet materials made of copper or a copper alloy to form one metal sheet for the metal layer 130 and a metal sheet for the circuit layer 120 and a bonding step of heating and bonding the metal sheet for the metal layer 130 and the metal sheet for the circuit layer 120 laminated on the ceramic substrate 11 through a brazing filler metal in a pressurized state. The metal sheet for the metal layer 130 is to serve as the metal layer 13, and the metal sheet for the circuit layer 120 has a predetermined shape (circuit pattern) and is to serve as the circuit layer 12. Hereinafter, the manufacturing method will be described in order of these steps.

### (Metal sheet formation step)

First, as shown in FIG. 3A, rolled sheets made of copper or a copper alloy (hereinafter, referred to as rolled copper materials) are punched by pressing to form the metal sheet for the metal layer 130 and the metal sheets for the circuit layer 120.

Specifically, the metal sheet for the metal layer 130 is formed into a rectangular sheet shape (for example, 40 mm x 50 mm) by pressing a rolled copper material having a thickness of 0.3 mm or more and 1.6 mm or less. The metal sheet for the circuit layer 120 is formed into a desired pattern shape (two rectangular punched sheets in the example shown in FIG. 2A) by pressing a rolled copper material having a thickness of 0.4 mm or more and 2.0 mm or less. That is, the metal sheet for the circuit layer 120 corresponds to a plurality of "punched sheets" of the present invention. The area ratio S1/S2 of the area S1 of the metal sheet for the circuit layer 120 formed as described above to the area S2 of the metal sheet for the metal layer 130 is set to 0.5 or more and 0.8 or less.

### (Bonding step)

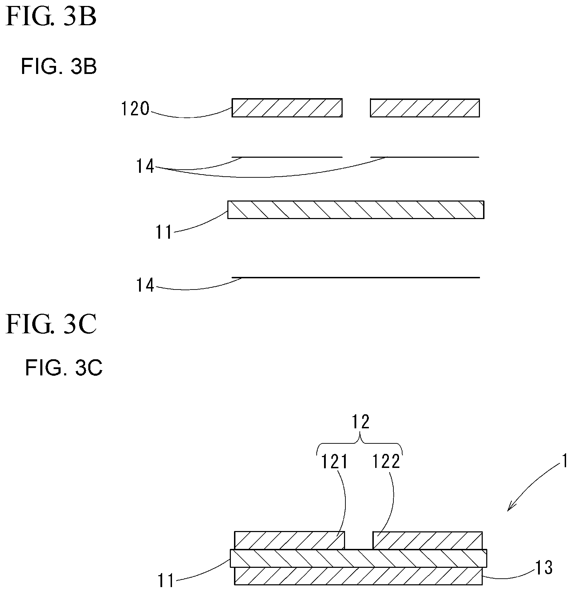

Next, as shown in FIG. 3B, the metal sheet for the metal layer 130 and the metal sheet for the circuit layer 120 are bonded to the ceramic substrate 11. Specifically, the metal sheet for the metal layer 130 and the metal sheet for the circuit layer 120 are laminated on the front surface and the back surface of the ceramic substrate 11 with Ag-Cu-Ti-based brazing filler metal foils 14 interposed therebetween. This laminate is sandwiched with carbon sheets and heated in a vacuum under a load applied in the laminating direction, thereby bonding the metal sheet for the metal layer 130 and the metal sheet for the circuit layer 120 to the ceramic substrate 11. Therefore, the insulated circuit board 1 in which the circuit layer 12 is bonded to the front surface of the ceramic substrate 11 shown in FIG. 3C through the bonding portion (brazing portion) and the metal layer 13 is bonded to the back surface through the bonding portion (brazing portion) is formed.

In this bonding step, the pressure applied in the laminating direction is preferably set to 0.1 MPa to 1.0 MPa, and the heating temperature is preferably set to 800°C to 930°C. In addition, the Ag-Cu-Ti-based brazing filler metal foil is preferably 5 µm to 15 µm in thickness. Furthermore, in addition to the Ag-Cu-Ti-based brazing filler metal, a Cu-P-based brazing filler metal can also be used.

In the insulated circuit board 1 manufactured by the above-described manufacturing method, the thickness T1 of the circuit layer 12 is 0.4 mm or more and 2.0 mm or less, the area ratio S1/S2 of the bonding area S1 of the circuit layer 12 to the bonding area S2 of the metal layer 13 becomes 0.5 or more and 0.8 or less, and the thickness ratio T1/T2 of the thickness T1 of the circuit layer 12 to the thickness T2 of the metal layer 13 becomes 1.2 or more and 1.7 or less.

Regarding residual stresses that are generated on the surfaces of the ceramic substrate 11, on the bonding surface with the circuit layer 12 or the metal layer 13, a compressive stress is generated. However, since the pattern is formed on the circuit layer 12 side, as shown in FIG. 2A, in the portion between the respective small circuit layers 121 and 122 (the region Ar1 exposed due to the formation of the pattern), a compressive stress is generated on the back side, and a tensile stress is generated on the front side. Therefore, the ceramic substrate is likely to warp such that the circuit layer 12 side becomes convex. In this case, as the circuit layer 12 and the metal layer 13 become thicker, the ceramic substrate more significantly warps.

In contrast, in the present embodiment, even when a residual stress is generated between the respective small circuit layers 121 and 122 (the region Ar1) on the ceramic substrate 11, since the thickness of the second metal layer 13 is thinner than the thickness of the circuit layer 12, it is possible to maintain the balance between the circuit layer 12-side surface and the metal layer 13-side surface of the ceramic substrate 11. Therefore, even in a case where the circuit layer 12 is formed by the pressing method instead of the etching method, it is possible to suppress a high-temperature warpage change during soldering.

The other detailed configurations are not limited to those in the configuration of the embodiment, and a variety of modifications can be added without departing from the gist of the present invention.

For example, in the above-described embodiment, an example in which the insulated circuit board 1 is used as a power module board has been described, but the insulated circuit board 1 can also be used as a variety of kinds of insulated boards such as a substrate for an LED element.

### EXAMPLE

Next, the effects of the present invention will be described in detail using examples, but the present invention is not limited to the following examples.

As members configuring specimens of Examples 1 to 7 and Comparative Examples 1 and 2, ceramic substrates that had a sheet thickness of 0.32 mm and were made of silicon nitride ceramic were prepared, and circuit layers and metal layers that had a sheet thickness and a bonding area shown in Table 1 and were formed of oxygen-free copper were prepared. The interval between two small circuit layers that configured the circuit layer was set to 1.0 mm.

In Table 1, the thickness of the circuit layer is indicated by T1 (mm), the thickness of the metal layer is indicated by T2 (mm), the bonding area of the circuit layer is indicated by S1 (mm²), and the bonding area of the metal layer is indicated by S2 (mm²).

These members were bonded together by the manufacturing method described in the above-described embodiment to produce insulated circuit boards, and the respective specimens of Examples 1 to 7 and Comparative Examples 1 and 2 were produced. In a series of heating tests designed to apply a temperature change such that a sample was heated from 30°C to 285°C and then cooled to 30°C, for each of the obtained specimens, the amount of warpage during heating to 285°C (warpage during heating) and the amount of warpage (returning warpage) at 30°C when the specimen had been heated to 285°C and then cooled to 30°C were respectively measured from the metal layer side. The amount of warpage was obtained by measuring the change of the ceramic substrate using a Moire-type three-dimensional shape measurement instrument, and the amount of change in the amount of warpage (difference between warpage during heating and returning warpage) was also obtained. The amount of warpage was expressed as "negative" in a case where the metal layer became concave and expressed as "positive" in a case where the metal layer became convex. The results are shown in Table 1.

**[Table 1]**

| | S1/S2 | T1 (mm) | T2 (mm) | T1/T2 | Warpage at 285°C (µm) | Returning warpage (µm) | Amount of change (µm) |
|---|---|---|---|---|---|---|---|
| Example 1 | 0.75 | 0.8 | 0.65 | 1.23 | 312 | -195 | 507 |
| Example 2 | 0.75 | 0.8 | 0.6 | 1.33 | 268 | -184 | 452 |
| Example 3 | 0.75 | 0.8 | 0.5 | 1.6 | 141 | -266 | 407 |
| Example 4 | 0.75 | 1.5 | 1 | 1.5 | -162 | 273 | 435 |
| Example 5 | 0.75 | 2 | 1.2 | 1.7 | 293 | 342 | 49 |
| Example 6 | 0.8 | 0.8 | 0.5 | 1.6 | 155 | -299 | 454 |
| Example 7 | 0.65 | 0.8 | 0.5 | 1.6 | 132 | -232 | 364 |
| Comparative Example 1 | 0.75 | 0.8 | 0.7 | 1.14 | 650 | -400 | 1050 |
| Comparative Example 2 | 0.75 | 0.8 | 0.4 | 2 | -523 | 320 | 843 |

As is clear from Table 1, it was possible to confirm that, in Examples 1 to 7 in which the area ratios S1/S2 of the bonding area S1 of the circuit layer to the bonding area S2 of the metal layer were 0.5 or more and 0.8 or less, the thickness ratios T1/T2 were 1.2 or more and 1.7 or less, the amounts of warpage were small at a high temperature during soldering or the like, and the amounts of change were also as small as 600 µm or less in the obtained insulated circuit boards.

### Industrial Applicability

It is possible to suppress a warpage change at a high temperature during soldering of an insulated circuit board.

### Reference Signs List

- 1: Insulated circuit board
- 11: Ceramic substrate
- 12: Circuit layer
- 13: Metal layer
- 14: Brazing filler metal foil
- 30: Element
- 31: Solder
- 100: Power module
- 120: Metal sheet for circuit layer (punched sheet)
- 130: Metal sheet for metal layer
- 121: Small circuit layer
- 122: Small circuit layer
- S1: Bonding area
- S2: Bonding area
- S11: Bonding area
- S12: Bonding area
- T1: Thickness of circuit layer
- T2: Thickness of metal layer
- T3: Thickness of ceramic substrate
- Ar1: Region

## Claims

1. An insulated circuit board comprising:
a ceramic substrate having a three-point bending strength, which is based on JIS 1601 2008, of 600 MPa or more;
a circuit layer that is made of copper or a copper alloy, includes a plurality of small circuit layers that is bonded to one surface of the ceramic substrate at an interval so as to form a predetermined shape, and has a thickness T1 of 0.4 mm or more and 2.0 mm or less; and
a metal layer that is made of copper or a copper alloy and is bonded to the other surface of the ceramic substrate,
wherein, when a bonding area of the circuit layer to the ceramic substrate is represented by S1, and a bonding area of the metal layer to the ceramic substrate is represented by S2, an area ratio S1/S2 is 0.5 or more and 0.8 or less, and
when a thickness of the metal layer is represented by T2, a thickness ratio T1/T2 is 1.2 or more and 1.7 or less.

2. The insulated circuit board according to claim 1,
wherein the ceramic substrate is made of silicon nitride.

3. The insulated circuit board according to claim 1 or 2,
wherein, in the circuit layer, each of the small circuit layers is made of a punched sheet.

4. The insulated circuit board according to any one of claims 1 to 3,
wherein, in the circuit layer, each of the small circuit layers is a polygonal flat sheet.

5. The insulated circuit board according to claim 4,
wherein each of the small circuit layers has a rectangular shape.

6. The insulated circuit board according to any one of claims 1 to 5,
wherein, in the circuit layer, the interval between the plurality of small circuit layers is 0.5 mm or more and 2.0 mm or less.

7. The insulated circuit board according to any one of claims 1 to 6,
wherein, in the circuit layer, the plurality of small circuit layers has the same composition.

8. The insulated circuit board according to any one of claims 1 to 7,
wherein the circuit layer and the metal layer have the same composition.
